(19) Europäisches Patentamt
European Patent Office
Office européen des brevets

(11) **EP 1 128 187 B1**

(12) **EUROPÄISCHE PATENTSCHRIFT**

(45) Veröffentlichungstag und Bekanntmachung des Hinweises auf die Patenterteilung:
**13.06.2007 Patentblatt 2007/24**

(51) Int Cl.:
***G01R 31/36*** *(2006.01)*

(21) Anmeldenummer: **01100540.2**

(22) Anmeldetag: **10.01.2001**

(54) **Verfahren zur Ermittlung des Ladezustandes von Bleiakkumulatoren**

Method for determining the state of charge of lead accumulators

Procédé pour déterminer l'état de charge des accumulateurs au plomb

(84) Benannte Vertragsstaaten:
**AT BE CH CY DE DK ES FI FR GB GR IE IT LI LU MC NL PT SE TR**

(30) Priorität: **23.02.2000 DE 10008354**

(43) Veröffentlichungstag der Anmeldung:
**29.08.2001 Patentblatt 2001/35**

(73) Patentinhaber: **VB Autobatterie GmbH & Co. KGaA**
**30419 Hannover (DE)**

(72) Erfinder:
- **Laig-Hörstebrock, Helmut, Dr.**
  **60320 Frankfurt (DE)**
- **Meissner, Eberhard, Dr.**
  **31515 Wunstorf (DE)**
- **Brunn, Detlef**
  **30823 Garbsen (DE)**
- **Leiblein, Karl-Heinz**
  **31515 Wunstorf (DE)**
- **Übermeier, Dieter**
  **30173 Hannover (DE)**

(74) Vertreter: **Lins, Edgar et al**
**Gramm, Lins & Partner GbR,**
**Theodor-Heuss-Strasse 1**
**38122 Braunschweig (DE)**

(56) Entgegenhaltungen:
**US-A- 5 703 469**

- **KAWAMURA A ET AL: "State of charge estimation of sealed lead-acid batteries used for electric vehicles" PESC 98 RECORD. 29TH ANNUAL IEEE POWER ELECTRONICS SPECIALISTS CONFERENCE (CAT. NO. 98CH36196), PROCEEDINGS OF POWER ELECTRONICS SPECIALIST CONFERENCE - PESC'98, FUKUOKA, JAPAN, 17-22 MAY 1998, Seiten 583-587 vol.1, XP002251909 1998, New York, NY, USA, IEEE, USA ISBN: 0-7803-4489-8**
- **PATENT ABSTRACTS OF JAPAN vol. 017, no. 522 (P-1616), 20. September 1993 (1993-09-20) & JP 05 142313 A (SHIKOKU ELECTRIC POWER CO INC;OTHERS: 02), 8. Juni 1993 (1993-06-08)**

EP 1 128 187 B1

**Beschreibung**

Die Erfindung betrifft ein Verfahren zur Ermittlung des Ladezustands von Bleiakkumulatoren durch Abschätzung ihrer Ruhespannung während des aktiven Betriebes im Fahrzeug.

Für zahlreiche Anwendungen ist es erforderlich, den aktuellen Ladezustand eines Akkumulators zu bestimmen. Ist zu einem bestimmten Zeitpunkt der aktuelle Ladezustand bekannt, so kann die Änderung des Ladezustands durch kontinuierliche Messung des fließenden Stromes und dessen Aufintegration nachvollzogen werden. Durch die mit diesem Verfahren verbundene Meßungenauigkeit verschlechtert sich jedoch die Aussagekraft des aktuellen Meßwertes immer weiter, so dass von Zeit zu Zeit ein Rücksetzen der Ladezustandsaussage mit Hilfe eines anderen Verfahrens erforderlich ist.

Im Falle eines Bleiakkumulators ist hierzu aufgrund ihrer direkten Verknüpfung mit dem Ladezustand die Beurteilung der aktuellen Ruhespannung des Akkumulators sehr geeignet (mit voranschreitender Entladung wird Schwefelsäure aus dem Elektrolyten verbraucht, und die Ruhespannung des Bleiakkumulators hängt eindeutig von der Säuredichte ab). Hierzu ist es jedoch erforderlich, dass der Betrieb des Akkumulators für eine gewisse Zeit unterbrochen wird, während der fließende Strom unter einem sehr niedrigen Schwellwert liegen muss. Denn nur im (fast) unbelasteten Zustand zeigt der Bleiakkumulator seine Ruhespannung, während er bei fließenden Lade- oder Entladeströmen eine davon zum Teil stark abweichende Spannung hat.

Auch im unbelasteten Zustand dauert es je nach Vorgeschichte oft noch lange, bis der innere Zustand des Akkumulators seinen Gleichgewichtswert und die Spannung ihren Ruhewert erreicht hat. Gerade bei modernen Akkumulatoren ist nach vorangegangenen Ladephasen und bei tiefen Temperaturen die erforderliche Dauer von Phasen ohne Strombeaufschlagung sehr lang, zum Teil viele Stunden bis hin zu einigen Tagen. Daher ist bei Betriebsarten ohne solche langen stromlosen Phasen das Verfahren der Messungen der Ruhespannung zur Bestimmung des Ladezustands im Allgemeinen nur bedingt geeignet. Ein Beispiel hierfür ist der Starterakkumulator im Kraftfahrzeug, wo oft nur Standzeiten von einigen Stunden oder etwa im Taxibetrieb - fast gar keine Standzeiten auftreten. Bei Raumtemperatur und darüber ist die aktuelle Ruhespannung, die man bei kurzzeitigem Wegschalten des Stromes erhielte, schon ein gutes Maß für die echte Ruhespannung des Akkumulators.

In der DE-19643012 A1 wird ein Verfahren angegeben, bei dem Leerlaufspannungswerte Uo aus den Nulldurchgängen des durch den Akkumulator fließenden Stromes genutzt werden, um die Spannungsreglung des Generators anzusteuern. Dieses Verfahren stellt erhöhte Anforderungen an die Messelektronik; der meist sehr rasche Durchgang durch den Nullpunkt des fließenden Stromes macht eine Interpolation notwendig, welche wegen den Nichtlinearitäten der Strom-/Spannungskurve bei kleinen Strömen nur schwer zu realisieren ist.

Der Erfindung liegt die Aufgabe zugrunde, ein Verfahren anzugeben, welches auch ohne künstliche Betriebsunterbrechung einen Rückschluss auf die aktuelle Ruhespannung des Akkumulators und auch eine Abschätzung der Ruhespannung während der Belastung des Akkumulators ermöglicht. Aufgrund der festen Korrelation zwischen Ruhespannung und Ladezustand kann daraus auf den aktuellen Ladezustand geschlossen werden.

Diese Aufgabe wird erfindungsgemäß durch das in Anspruch 1 angegebene Verfahren gelöst. In den Unteransprüchen sind vorteilhafte Weiterbildungen des Verfahrens angeführt. Das erfindungsgemäße Verfahren besteht im wesentlichen aus zwei Schritten, nämlich zuerst einer Bestimmung der Spannung Uo, die die Batterie beim kurzfristigen Wegschalten der Last hätte und daran anschließend eine Berechnung des Ladezustandes aus der so erhaltenden Ruhespannung.

Beim erfindungsgemäßen Verfahren wird eine große Zahl von Messpunkten verwertet und daher können Streuungen besser abgefangen werden und die Genauigkeit deutlich erhöht werden.

Die momentane lastfreie Spannung wird dadurch gewonnen, dass regelmäßig zeitgleich Messwertepaare ($U_i$, $I_i$) der aktuellen Spannung und des Stromes gemessen werden, und durch eine Ausgleichsrechnung an eine Widerstandsbeziehung mit mehreren freien Parametern angepasst werden. Einer der Parameter ist eine Näherung für die aktuelle lastfreie Batteriespannung Uo.

Im Folgenden wird die übliche Vorzeichenregelung für Batterieströme verwendet:
Ladeströme werden für den Akkumulator stets als positive Ströme, Entladeströme stets als negative Ströme angegeben.

Beim erfindungsgemäßen Verfahren wird eine Auswahl unter den für das Verfahren heranzuziehenden Messwertepaaren ($U_i$, $I_i$) vorgenommen. Ziel ist dabei sicherzustellen, dass insbesondere aus vorangegangenen Ladephasen resultierende Ungleichgewichtszustände der Elektroden bereits abgebaut sind, weil die Verwendung von Messwertepaaren ($U_i$, $I_i$) aus solchen Zuständen zu falschen Aussagen führen kann.

Insbesondere werden nur solche Messwertepaare ($U_i$, $I_i$) verwendet, die in einer Entladephase liegen, d.h. bei denen der aktuelle Strom und der Strom bei der vorangegangenen Messung kleiner sind als Null. Weiterhin wird darauf geachtet, dass eine eventuell vorangegangene Ladephase (mit Stromwerten größer als Null) hinreichend lange zurückliegt

Für die erfindungsgemäße Bestimmung der momentanen Spannung für Strom Null aus einer Anzahl von Messwertepaaren ($U_i$, $I_i$) hat sich ein Widerstandsansatz der Form

$$(1) \quad U_i = Uo + R * I_i + [a * I_0 \, \text{arcsinh}(I_i|_0) - a * I_i] + 1/C \int I_i \, dt$$

bewährt. Uo, R, a, $I_0$ und C sind dabei die zu variierenden Parameter.

R und a haben die Dimension Widerstand, $I_0$ hat die Dimension Stromstärke, C hat die Dimension einer Kapazität, und Uo stellt die nach diesem Algorithmus ermittelte Ruhespannung dar.

Der Term mit den Parametern a und $I_0$ berücksichtigt Nichtlinearitäten und ist insbesondere bei starken Stromänderungen erforderlich. Ansonsten kann er zur Vereinfachung meist weggelassen werden. Der letzte Teil der Gleichung berücksichtigt kapazitive Effekte in der Batterie durch Integration des geflossenen Stromes. Damit ergibt sich eine vereinfachte Gleichung:

$$(2) \quad U_i = Uo + R * I_i + 1/C \int I_i \, dt$$

Bei Messwertstreuungen oder bei überlagertem Rauschen müssen die systematischen Signale natürlich entsprechend groß sein, um eine ausreichende Genauigkeit zu erzielen. Eine Bestimmung des Korrelationskoeffizienten zwischen Strom und Spannung kann darüber Auskunft geben.

Beim erfindungsgemäßen Verfahren zur Abschätzung der aktuellen Ruhespannung eines Bleiakkumulators werden somit

- zeitgleich Messwertepaare $(U_i, I_i)$ von Akkumulatorspannung und fließendem Strom zum Zeitpunkt $t_i$ mit einem zeitlichen Abstand dt aufgenommen, wobei nur solche Wertepaare Berücksichtigung finden, für die im letzten Zeitintervall ausschließlich ein Entladestrom geflossen ist,

- dann werden mit einer Gruppe von so ausgewählten Messwertpaaren $(U_i, I_i)$ die Parameter Uo, R und O in solcher Weise variiert, dass die Summe der Fehlerabweichungsquadrate zwischen den durch die Formel

$$(2) \quad U_i = Uo + R * I_i + 1/C \int I_i \, dt$$

gegebenen Werten $U_i$ und den gemessenen Weiten $U(t_i)$ minimiert wird,

- schließlich wird aus der so erhaltenen Spannung auf den Ladezustand des Akkumulators geschlossen (Dabei ist R ein Faktor von der Dimension Widerstand, C hat die Dimension einer Kapazität und Uo stellt die nach diesem Algorithmus ermittelte Ruhespannung dar.)

Um mit höherer Genauigkeit zu arbeiten, wird die Formel

$$(1) \quad U_i = Uo + R * I_i + [a * I_0 * \text{arcsinh}(I_i / I_0) - a * I_i] + 1/C \int I_i \, dt$$

verwendet (Dabei sind R und a Faktoren von der Dimension Widerstand, $I_0$ ist ein Faktor von der Dimension Stromstarke, C hat die Dimension einer Kapazität und Uo stellt die nach diesem Algorithmus ermittelte Ruhespannung dar.)

In weiterer Ausgestaltung des Verfahrens werden die aus Gleichung (1) oder (2) bestimmten Uo mit zeitlich vorhergehenden Werten verglichen und nur solche Wertepaare (U, I) werden berücksichtigt, für die nachstehende Relation gilt

$$(3) \quad dUo/dq = (Uo(t_n) - Uo(t_{n-1})) / q(t_n) - q(t_{n-1})) < Dgr$$

Der Grenzwert Dgr pro Zelle wird aus dem Bereich 6V/Qo bis -6V/Qo, vorzugsweise mit der Bedingung Abs(Dgr)<=1V/Qo gewählt Qo ist dabei die Kapazität der Batterie.

Es hat sich bewährt, die berechneten Uo mit einem oder zwei Nachbarwerten noch einmal zu mitteln, und dann erst Kriterium Gleichung (3) anzuwenden, um zu entscheiden, ob diese Werte Uo als Ausgangspunkt für eine Bestimmung der Ruhespannung geeignet sind.

Ersatzweise sollte, bevor Messwerte genommen werden, eine ausreichend lange Endade-Phase (mit einem Strom kleiner als Null) vorgeschaltet sein und zwar so, dass die während ihrer Dauer entladene Ladungsmenge $Q^-$ die während einer vorangegangenen Ladephase (mit einem Strom größer als Null) eingeladenen Ladungsmenge $Q^+$ zumindest ausgleicht.

Gegebenenfalls kann auch eine gezielte Entladung einer Ladungsmenge Q erfolgen, um dieses Ziel zu erreichen.

Die dazu erforderliche Ladungsmenge $Q^-$ ist erfahrungsgemäß nicht größer als etwa 2-3% der Batteriekapazität. Es reicht also eine entsprechende Entladungsladungsmenge $Q^- < 2-3\%$ der Batteriekapazität, um das reine Entladungsgebiet zu erreichen.

Eine Abschätzung für die hierzu maximal notwendige Entladungsmenge $Q^-$ eines Starterakkumulators mit Nennspannung 12V und Batteriekapazität Qo ist:

$$(4) \qquad Q^- \ = \ Qo \ ^* (U - 12V) / 60V,$$

wobei U für die in einer kurzen Strompause gemessene Batteriespannung steht.

Ein besonders günstiger erfindungsgemäßer Sonderfall liegt vor, wenn die während der Entladung der Ladungsmenge $Q^-$ auftretende (negative) Überspannung im Mittel höher ist als die während der vorangegangenen Ladung aufgetretene (positive) Überspannung.

Das Zeitintervall, aus dem die Messwertepaare $(U_i, I_i)$ genommen werden, wird beispielsweise so gewählt, dass sich der Ladezustand in dieser Periode um weniger als 5%, vorzugsweise um weniger als 2% der Batteriekapazität vermindert.

Die bei der Durchführung der Ausgleichsrechnung erhaltenen Parameter (einschließlich der momentanen Ruhespannung) können im Allgemeinen vom Ladezustand und der Batterietemperatur abhängen. Deshalb sollten diese Größen sich während der Phase, aus der Messwertepaare $(U_i, I_i)$ gewählt werden, möglichst wenig ändern. Die Dauer der Phase ist gegebenenfalls entsprechend zu begrenzen. Die Abschätzung der Dauer orientiert sich z.B. an der durch Integration des geflossenen Stromes detektierten eingetretenen Änderung des Ladezustandes.

Weiterhin ist es für die Genauigkeit des Verfahrens anzustreben, dass der Entladestrom bei den ausgewählten Messwertepaaren $(U_i, I_i)$ nicht konstant ist, sondern sich möglichst ändert. Auch hier kann eine entsprechende Selektion der verwendeten Messwertepaare $(U_i, I_i)$ oder alternativ eine gezielte Beaufschlagung mit wechselnden Stromlasten erfolgen. Auch kann erfindungsgemäß eine Synchronisation der Messdatenerfassung mit dem Ein- und Ausschalten von elektrischen Verbrauchern, insbesondere auch von gepulst betriebenen Verbrauchern, vorgenommen werden, um den gewünschten Effekt zu erzielen. Insbesondere gilt das erfindungsgemäße Verfahren natürlich auch für den von einer Batterie gespeisten Startvorgang.

Somit wird die Auswahl der für die Anpassung an die Funktion (1) oder (2) verwendeten Messwertepaare $(U_i, I_i)$ so getroffen, dass die fließenden (Entlade-)Ströme $I_i$ nicht konstant sind, sondern beispielsweise Änderungen mindestens in der Größenordnung von 0,01 A pro Ah der Batteriekapazität aufweisen.

Eine Synchronisation der Messdatenerfassung und des Ein- und Ausschaltens von Lasten, insbesondere mit pulsgesteuerten Lasten, erfolgt in solcher Weise, dass Messwertepaare $(U_i, I_i)$ mit unterschiedlichen Stromstärken $I_i$ erhalten werden. Es kann auch das Ein- und Ausschalten von Lasten provoziert werden und zwar in solcher Weise, dass Messwertepaare $(U_i, I_i)$ mit unterschiedlichen Stromstärken $I_i$ erhalten werden.

Das Verfahren kann ergänzt werden durch eine Beurteilung des Spannungsverhaltens nach vorangegangener Ladung, indem die zeitliche Veränderung beobachtet wird und dann, wenn diese einen unteren Schwellwert unterschreitet, der aktuelle Spannungsmesswert als Näherungswert für die Ruhespannung verwendet wird. Ist diese Bedingung noch nicht erfüllt, so wird die oben genannte gezielte dosierte Entladung vorgenommen.

Der mittlere während der Entladephase fließende Strom sollte nicht zu hoch sein, um nicht erneute Inhomogenitäten in den Elektroden und im Elektrolyten zu schaffen.

Eine andere, für die Praxis sehr vorteilhafte Vorgehensweise besteht darin, für die Vorauswahl der Messpunkte zunächst nur die Einschränkung eines negativen (d.h. Entlade-) Stromes gelten zu lassen, dann die Parameteranpassung durchzuführen, und erst dann aus dem so gewonnenen Wert Uo entsprechend einem Kriterium die zu verwendenden Werte zu selektieren. D.h. Auswahl derjenigen Messpunkte, die letztendlich zur Bestimmung des Ladezustandes herangezogen werden, erfolgt erst nach Prüfung ihrer Tauglichkeit.

Vorteilhaft ist es, so zu verfahren, dass man die nach Formel (2) berechnete lastfreie Spannung Uo zum Zeitpunkt $t_n$ mit derjenigen für einen vorhergehenden Zeitpunkt $t_{n-1}$ erhaltenen vergleicht. Dabei werden nur solche Werte Uo für die Berechnung des Ladezustandes verwendet, für die eine nur schwache Abhängigkeit der Spannung Uo von der zwischen den Zeitpunkten $t_n$ und $t_{n-1}$, geflossenen Ladungsmenge festgestellt wird. Dies sind Werte für die gilt:

$$(3) \qquad dUo / dq = ( Uo(t_n) - Uo(t_{n-1}) ) / ( q(t_n) - q(t_{n-1}) ) < Dgr$$

Der Grenzwert Dgr wird aus dem Bereich 6V/Qo bis -6V/Qo pro in Serie geschaltete Zelle des Akkumulators, vorzugsweise mit der Bedingung Abs(Dgr)<=1V/Qo gewählt. Qo ist dabei die Kapazität der Batterie.

Es ist auch möglich, von den erfindungsgemäß bestimmten Werten Uo nur solche Werte zu selektieren, für die die lineare Regression an die Werte Uo gegen die umgesetzte Ladung eine Neigung hat die kleiner ist als Dgr, wobei Dgr pro Batteriezelle aus dem Bereich von 6V/Qo bis -6V/Qo gewählt wird, vorzugsweise mit der Bedingung Abs(Dgr) < 1V/Qo.

Eine weitere Verbesserung der Genauigkeit der Vorhersage ergibt sich dadurch, dass der zu einem bestimmten Zeitpunkt $t_o$ erhaltene Ladezustandswert SOC $(t_o)$ zur Bestimmung des Ladezustandes zur allgemeinen Zeit t mit anderen Verfahren zur Ermittlung des Ladezustandes oder aber mit Verfahren zur Ermittlung der Änderung des Ladezustands $\Delta$SOC $(t_o,t)$ in der Zeit von $t_o$ bis t verknüpft wird, wobei vorteilhaft $\Delta$SOC $(t_o,t)$ aus der durch Integration des durch den Akkumulator fließenden Stromes ermittelten umgesetzten Ladungsmenge berechnet wird.

In weiterer Ausbildung des Verfahrens werden die zu verschiedenen Zeiten $t_i$, erhaltenen (fehlerbehafteten) Ladezustandswerte SOC $(t_i)$ mit anderen Verfahren zur Ermittlung (fehlerbehafteter) Ladezustandswerte oder aber mit Verfahren zur Ermittlung der (fehlerbehafteten) Änderung des Ladezustands $\Delta$SOC $(t_i, t_{i+1})$ in der Zeit von $t_i$ bis $t_{i+1}$ verknüpft, und so ein aktueller Ladezustandswert SOC ermittelt, wobei dieser Wert durch Anwendung eines Minimalisierungsverfahrens, vorzugsweise der Methode der kleinsten Fehlerquadrate, erhalten wird.

Die erhaltenen Spannungswerte Uo können auch mit einem Grenzwert Uo-min verglichen werden, und die Unterschreitung wird angezeigt und/oder eine Maßnahme wird ergriffen. Der Grenzwert Uo-min wird so gewählt, dass er etwa der Gleichgewichtsspannung des Akkumulators nach Entnahme seiner Nennkapazität entspricht.

Zusammenfassend ergibt sich erfindungsgemäß folgende Vorgehensweise:

1. Messung der Spannung U(t) und des Stromes I(t)
2. Falls I(t) > 0, dann wird die Messung verworfen, gehe zu 1.; sonst
3. Falls die vorangegangenen Messungen I(t-1), I(t-2), ... > 0, gehe zu 1.; sonst
4. Wende Gleichung (1) oder (2) auf eine Menge von Wertepaaren U, I an, und erhalte so Uo
5. (OPTIONAL: Mittele über einige so erhaltene Uo, sofern dazwischen kein Messwert mit 1 > 0 gelegen hat)
6. Wende Gleichung (3) an und stelle fest, ob die Entladung im Bereich mit geringer Abhängigkeit der Spannung von der entnommenen Ladungsmenge liegt; falls nein, so wird verworfen, gehe zu 1.; sonst
7. Berechne aus Uo den Ladezustand über den Zusammenhang von Spannung, Elektrolytkonzentration und Ladezustand.

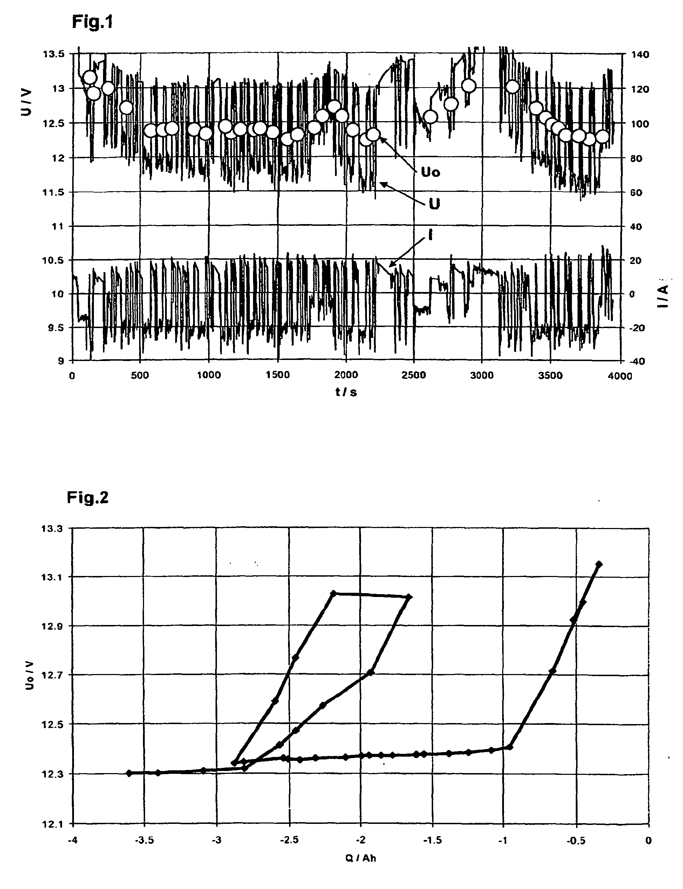

Im Folgenden ist anhand der Beispiele 1 bis 5 und der Figuren 1 bis 4 das Verfahren noch näher erläutert.

**Beispiel 1**

Figur 1 zeigt den typischen Verlauf von Strom und Spannung an einer Fahrzeugbatterie bei einer Stadtfahrt. Es handelt sich um eine sechszellige Bleibatterie mit 48Ah Kapazität. Die Batterie befindet sich in einem Ladezustand von ca. 70%.

Auf diesen Fahrzyklus wurde der beschriebene Algorithmus angewendet, d.h. Anpassung der Parameter in Gleichung (1) mit der erwähnten Vereinfachung a=0 und io=0. Die erhaltenen Werte für sämtliche Uo sind als Kreise in Figur 1 eingetragen.

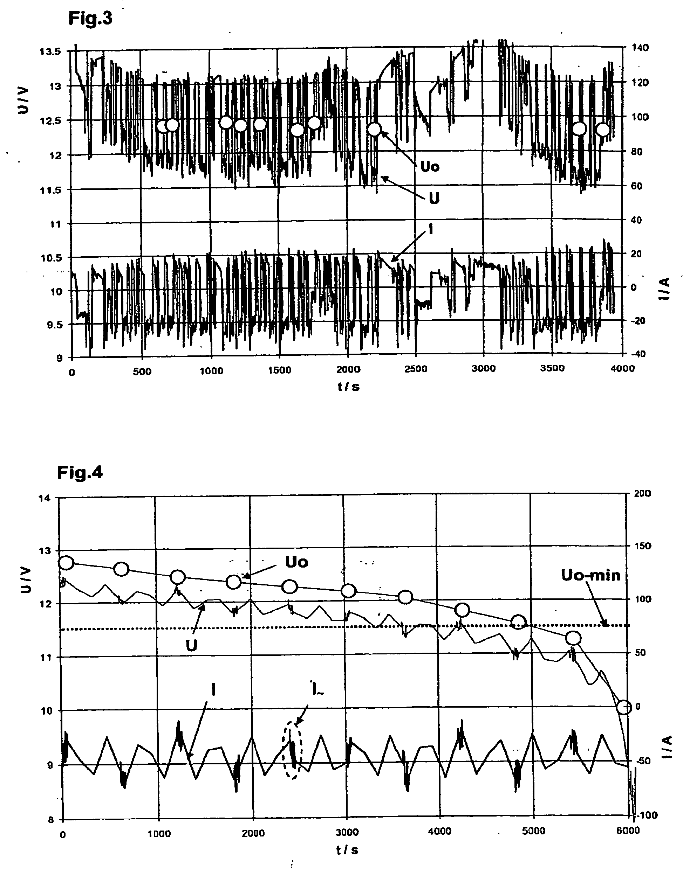

Die Auswahl der möglicherweise zur Ermittlung des Ladezustandes tauglichen Punkte Uo erkennt man in Figur 2. Dort, wo die Kurve flach verläuft, liegen die nutzbaren Werte. Es empfiehlt sich eine Mittelung der Werte vorzunehmen und dann das Kriterium Gleichung (3) anzuwenden. Die Werte Uo, die nach Anwendung des Kriteriums Gleichung (3) mit Dgr=0.1 übrigbleiben, sind in Figur 3 dargestellt.

Das Ergebnis zeigt, dass die Bestimmung der Ruhespannung Uo in diesem Beispiel nach Entnahme von ca. 1Ah möglich ist. Man erhält einen Ruhespannungswert von ca. 12.4 V. Hieraus ergibt sich bei der konkreten Batterie über den Zusammenhang von Ruhespannung und Ladezustand ein Ladezustand von ca. 67%, in guter Übereinstimmung mit dem Ausgangswert von ca. 70% minus der zwischenzeitlich entnommenen ca. 1,5Ah.

**Beispiel 2:**

In Betriebsphasen mit geringer Stromdynamik können Zustände mit wechselnder Stromstärke provoziert werden, um das erfindungsgemäße Verfahren anwenden zu können.

Als wechselnde Last bei einer Batterie von z.B. 80Ah Nennkapazität wird z.B. ein Strom von 20A Amplitude für eine Zeitperiode von z.B. 30s Dauer z.B. alle 3s ein- und ausgeschaltet und die Spannung und Ströme mit einem Messtakt von z.B. 0.5s registriert. Nach dieser Periode kann ein weiterer Stromdurchsatz (z.B. ein durch den bestimmungsgemäßen Betrieb verursachter konstanter Strom von z.B. 5A) entnommen werden, bis insgesamt eine Ladungsmenge von ca. 0.25 Ah entnommen sind.

Dann erfolgt eine Wiederholung der obigen Wechsellast für weitere 30s.

Nach Auswertung der Spannungs-/Strompaare jeder Wechsellast bleiben insgesamt 6 Anpassungsparameter (die 5 Größen Uo, R, a, $I_o$, C aus Gleichung.(1) sowie q) übrig, die langfristig gespeichert werden müssen.

Günstig ist eine häufigere Wiederholung dieses Vorgehens.

Aus zwei solchen Phasen mit Wechsellast wird zuerst darauf geschlossen, ob die Messpunkte brauchbar waren, und wenn ja, dann wird daraus die Ruhespannung abgeschätzt.

Wenn den Signalen höherfrequente Anteile überlagert sind, ist ein Messtakt von 0.5s nacht ausreichend; es ist dann vorteilhaft, mit beispielsweise 0.1s Messtakt zu registrieren und beispielsweise auf 1s zu mitteln ("Tiefpassfilter").

**Beispiel 3:**

Das erfindungsgemäße Verfahren ist geeignet, unter bestimmten Betriebsbedingungen auf die aktuelle Ruhespannung $Uo(t_o)$ des Akkumulators zur Zeit $t_o$ und daraus auf seinen Ladezustand SOC $(t_o)$ zu schließen, auch wenn der Akkumulator mit Strom beaufschlagt wird. Bei anderen Betriebsbedingungen ist eine Anwendung jedoch möglicherweise nicht möglich, weil die Voraussetzungen nicht gegeben sind.

Um auch in diesen allgemeinen Fällen zur Zeit t eine Aussage über den aktuellen Ladezustand zu ermöglichen, liegt es im Rahmen der Erfindung, eine Verknüpfung mit anderen Verfahren zur Bestimmung des Ladezustandes vorzunehmen.

Vorteilhaft handelt es sich dabei z.B. um Verfahren zur Bestimmung der Änderung des Ladezustandes ΔSOC, z.B. durch die Aufintegration des in der Zeit von $t_o$, bis t geflossenen Stromes I.

In diesem Falle gilt beispielsweise:

$$\text{SOC }(t) \quad = \text{ SOC }(t_o) \text{ + } \Delta\text{SOC }(t_o,t)$$

mit $\Delta\text{SOC }(t_o,t) = 1/Qo \int I dt$.

**Beispiel 4:**

Das erfindungsgemäße Verfahren ist geeignet, unter bestimmten Betriebsbedingungen auf die aktuelle Ruhespannung $Uo(t_o)$ des Akkumulators zur Zeit $t_o$ und daraus auf seinen Ladezustand SOC $(t_o)$ zu schließen, auch wenn der Akkumulator mit Strom beaufschlagt wird.

Weiterhin kann entsprechend Beispiel 3 eine Verknüpfung mit Verfahren zur Bestimmung der Änderung des Ladezustandes ΔSOC erfolgen.

Sowohl die Bestimmung des Ladezustandes SOC $(t_o)$ wie die Bestimmung der Änderung des Ladezustandes ΔSOC ist jedoch mit einem Messfehler verbunden, der sich aus der Ungenauigkeit der Messungen von Spannung und Zeit und beliebigen anderen Fehlerquellen zusammensetzt.

Wird im kontinuierlichen Betrieb wiederholt, z.B. n-mal, der aktuelle Ladezustand SOC $(t_i)$ zu verschiedenen Zeiten $t_i$ (i = 1, 2, .., n) bestimmt und auch die Änderung des Ladezustandes ΔSOC $(t_i, t_i+_1)$ zwischen diesen Zeitpunkten, so erhält man ein überbestimmtes Problem.

Es liegt im Rahmen der Erfindung, durch Verwendung eines Minimierungsverfahrens hieraus einen Ladezustand zu berechnen, und so die oben genannten Fehler zu mindern. Die Schärfe des Verfahrens wird hierdurch um so mehr erhöht, je mehr unabhängige Bestimmungen des Ladezustandes möglich sind.

Es liegt ebenfalls im Rahmen der Erfindung, eine Verknüpfung mit anderen Verfahren zur Bestimmung des Ladezustandes vorzunehmen, um so die Zahl unabhängiger Bestimmungen des Ladezustandes zu erhöhen.

**Beispiel 5**

Bei tieferen Temperaturen (<0°C) besteht eine merkliche Abweichung zwischen dem berechneten Uo und der Ruhespannung des Akkumulators, die sich nach langer Wartezeit einstellen würde. Aber auch in diesen Fällen ist Uo eine wertvolle Größe. Es wurde festgestellt, dass Uo als Vorwarnung für einen bei gleichbleibender mittlerer Last bald bevorstehenden Zusammenbruch der Batteriespannung verwendet werden kann. Ein repräsentatives Beispiel zeigt Figur 4: Dort ist die Spannungsantwort U einer Batterie auf den aufgeprägten Strom I aufgetragen. Dieses Profil enthält langsame Stromänderungen und solche, die etwa einer Frequenz von 1 bis 0.3Hz entsprechen. Ein Beispiel dafür ist durch I gekennzeichnet. Für die Auswertung werden die schnelleren Stromänderungen verwendet. In Figur 4 sind die entsprechend dem erfindungsgemäßen Verfahren ermittelten Uo Werte als große Kreise eingetragen. Wenn Uo etwa den Wert Uo-min=11.5V/6Zellen unterschreitet, erfolgt der Spannungszusammenbruch sehr bald. Es hat sich gezeigt, dass dann im allgemeinen noch ca. 10 bis 20% der Batteriekapazität zur Verfügung stehen.

**Patentansprüche**

1.  Verfahren zur Bestimmung des Ladezustands von Bleiakkumulatoren durch Abschätzung der aktuellen Ruhespannung, **dadurch gekennzeichnet, dass** zeitgleich Messwertepaare $(U_i, I_i)$ von Akkumulatorenspannung und fließendem Strom zum Zeitpunkt $t_i$ mit einem zeitlichen Abstand dt aufgenommen werden, wobei nur solche Wertepaare Berücksichtigung finden, für die im letzten Zeitintervall ausschließlich ein Entladestrom geflossen ist, dass mit einer Gruppe von so ausgewählten Messwertpaaren $(U_i, I_i)$ die Parameter Uo, R und C in solcher Weise variiert werden, dass die Summe der Fehlerabweichungsquadrate zwischen den durch die Formel

$$U_1 = Uo + R * I_i + 1/C \int I_i \, dt \tag{1}$$

    gegebenen Werten $U_i$ und den gemessen Werten $(U(t_i))$ minimiert wird, und dass aus der so erhaltenen Ruhespannung $U_o$ auf den Ladezustand des Akkumulators geschlossen wird, wobei R ein Faktor von der Dimension Widerstand ist, C die Dimension einer Kapazität hat und $U_o$ die nach diesem Algorithmus ermittelte Ruhespannung darstellt.

2.  Verfahren nach Anspruch 1, **dadurch gekennzeichnet, dass** mit einer Gruppe von so ausgewählten Messwertepaaren $(U_i, I_i)$ die Parameter Uo, r, a, $i_0$ und C in solcher Weise variiert werden, dass die Summe der Fehlerabweichungsquadrate zwischen den durch die Formel

$$U_i = Uo + R * I_i + [a * i_0 * arcsinh(I_i / i_0) - a * I_i] + 1/C \int I_i \, dt \tag{2}$$

    gegebenen Werten $U_i$ und den gemessenen Werte $U(t_i)$ minimiert wird; und dass aus der so erhaltenen Spannung auf den Ladezustand des Akkumulators geschlossen wird, wobei R und a Faktoren von der Dimension Widerstand sind, $i_0$ ein Faktor von der Dimension Stromstärke ist, C die Dimension einer Kapazität hat und $U_o$ die nach diesem Algorithmus ermittelte Ruhespannung darstellt.

3.  Verfahren nach Anspruch 1 oder 2, **dadurch gekennzeichnet, dass** bestimmte Uo mit zeitlich vorhergehenden Werten verglichen werden und dass nur solche Werte Uo berücksichtigt werden, für die die Relation gilt:

$$dUo/dq = (Uo(t_n) - Uo(t_{n-1})) / (q(t_n) - q(t_{n-1})) < Dgr \tag{3}$$

    wobei der Grenzwert Dgr pro Zelle aus dem Bereich 6V/Qo bis -6V/Qo, vorzugsweise mit der Bedingung Abs(Dgr) <=1V/Qo gewählt wird und Qo dabei die Kapazität der Batterie ist.

4.  Verfahren nach Anspruch 1 oder 2, **dadurch gekennzeichnet, dass** lediglich solche Messwertpaare $(U_i, I_i)$ verwendet werden, bei denen $I_i < 0$ und seit dem letzten Messwert mit einem positiven Strom und einem Zeitintervall dt mit positiven Beitrag $Q^+$ zum Ladezustand folgende Bedingung erfüllt ist:

der Betrag von Q⁻ ist entweder größer als der Betrag von Q⁺, oder aber der Betrag von Q⁻ ist größer als 2% der Batteriekapazität,

wobei Q⁻ die (entladene) Ladungsmenge darstellt, die seit dem letzten Messpunkt mit positivem Batteriestrom in einer ununterbrochenen Entladephase entnommen wurde,

und Q⁺ die (geladene) Ladungsmenge darstellt, die in der letzten ununterbrochenen (Lade-)Phase mit positivem Batteriestrom eingeladen wurde.

5. Verfahren nach einem oder mehreren der Ansprüche 1 bis 4, **dadurch gekennzeichnet, dass** eine Synchronisation der Messdatenerfassung und des Ein- und Ausschaltens von Lasten, insbesondere mit pulsgesteuerten Lasten, in solcher Weise erfolgt, dass Messwertepaare ($U_i$, $I_i$) mit unterschiedlichen Stromstärken $I_i$ erhalten werden.

6. Verfahren nach einem oder mehreren der Ansprüche 1 bis 5, **dadurch gekennzeichnet, dass** das Ein- und Ausschalten von Lasten provoziert wird und zwar in solcher Weise, dass Messwertepaare ($U_i$, $I_i$) mit unterschiedlichen Stromstärken $I_i$ erhalten werden.

7. Verfahren nach einem oder mehreren der Ansprüche 1 bis 6, **dadurch gekennzeichnet, dass** der so zu einem bestimmten Zeitpunkt $t_o$ erhaltene Ladezustandswert SOC ($t_o$) zur Bestimmung des Ladezustandes zur allgemeinen Zeit t mit anderen Verfahren zur Ermittlung des Ladezustandes oder aber mit Verfahren zur Ermittlung der Änderung des Ladezustands $\Delta$SOC ($t_o$,t) in der Zeit von $t_o$ bis t verknüpft wird, wobei vorzugsweise $\Delta$SOC ($t_o$,t) aus der durch Integration des durch den Akkumulator fließenden Stromes ermittelten umgesetzten Ladungsmenge berechnet wird.

8. Verfahren nach einem oder mehreren der Ansprüche 1 bis 7, **dadurch gekennzeichnet, dass** die zu verschiedenen Zeiten $t_i$ erhaltenen Ladezustandswerte SOC ($t_i$) mit anderen Verfahren zur Ermittlung von Ladezustandswerten oder mit Verfahren zur Ermittlung der Änderung des Ladezustands $\Delta$SOC ($t_i$, $ti_{+1}$) in der Zeit von $t_i$ bis $t_{i+1}$ verknüpft wird, und durch Anwendung eines Minimalisierungsverfahrens ein aktueller Ladezustandswert SOC ermittelt wird.

9. Verfahren nach einem oder mehreren der Ansprüche 1 bis 8, **dadurch gekennzeichnet, dass** die erhaltenen Spannungswerte Uo mit einem Grenzwert Uo-min verglichen werden, und die Unterschreitung angezeigt und/oder eine Maßnahme ergriffen wird.

10. Verfahren nach einem oder mehreren der Ansprüche 1 bis 9, **dadurch gekennzeichnet, dass** der Grenzwert Uo-min so gewählt wird, dass er etwa der Gleichgewichtsspannung des Akkumulators nach Entnahme seiner Nennkapazität entspricht.

**Claims**

1. Method for determination of the state of charge of lead-acid rechargeable batteries by estimation of the instantaneous rest voltage, **characterized in that** measurement value pairs ($U_i$, $I_i$), of the rechargeable battery voltage and current flowing at the time $t_i$ are recorded simultaneously with a time interval dt with the only value pairs which are considered being those for which exclusively a discharge current has flowed in the last time interval, **in that** the parameters Uo, R and C are varied with a group of measurement value pairs ($U_i$, $I_i$) selected in this way, in such a way that the sum of the error squares between the values $U_i$ given by the formula

$$U_i = Uo + R*I_i + 1/C \int I_i \, dt \qquad (1)$$

and the measured values U($t_i$) is minimized, and **in that** the state of charge of the rechargeable battery is deduced from the rest voltage $U_0$ obtained in this way, with R being a factor whose dimension is resistance, C having the capacitance dimension, and $U_0$ representing the rest voltage determined using this algorithm.

2. Method according to Claim 1, **characterized in that** the parameter Uo, R, a, $i_0$ and C are varied with a group of measurement value pairs ($U_i$, $I_i$) selected in this way, in such a way that the sum of the error square between the values $U_i$ given by the formula

$$U_i = Uo + R*I_i + [a*i_0*arcsinh(I_i/i_0) - a*I_i] + 1/C \int I_i dt \quad (2)$$

and the measured values $U(t_i)$ is minimized, and **in that** the state of charge of the rechargeable battery is deduced from the voltage obtained in this way, with R and a being factors whose dimension is resistance, $i_0$ being a factor whose dimension is the current level, C having a capacitance dimension and $U_0$ representing the rest voltage determined using this algorithm.

3. Method according to Claim 1 or 2, **characterized in that** specific Uo are compared with previous values, and **in that** the only values Uo which are considered are those for which the following relationship is satisfied:

$$dUo/dq = (Uo(t_n) - Uo(t_{n-1}))/(q(t_n) - q(t_{n-1})) < Dgr \quad (3)$$

with the limit value Dgr per cell being selected from the range 6V/Qo to -6V/Qo, preferably subject to the condition Abs(Dgr)<=1V/Qo, and the Qo in this case being the capacity of the battery.

4. Method according to Claim 1 or 2, **characterized in that** the only measurement value pairs ($U_i$, $I_i$) which are used are those for which $I_i < 0$ and for which the following condition is satisfied since the last measurement value with a positive current and a time interval dt with a positive contribution $Q^+$ to the state of charge:

the magnitude of $Q^-$ is either greater than the magnitude of $Q^+$, or else the magnitude of $Q^-$ is greater than 2% of the battery capacity,
where $Q^-$ represents the (discharge) amount of charge which has been drawn since the last measurement point with a positive battery current in an uninterrupted discharge phase, and $Q^+$ represents the (charge) amount of charge which has been charged in the last uninterrupted (charging) phase with a positive battery current.

5. Method according to one or more of Claims 1 to 4, **characterized in that** the measurement data detection and the switching on and off of loads, in particular of pulse-controlled loads, are synchronized in such a way that measurement value pairs ($U_i$, $I_i$) with different current levels $I_i$ are obtained.

6. Method according to one or more of Claims 1 to 5, **characterized in that** the switching on and off of loads is predicted, to be precise in such a way that measurement value pairs ($U_i$, $I_i$) with different current levels $I_i$ are obtained.

7. Method according to one or more of Claims 1 to 6, **characterized in that** the state of charge SOC (to) obtained for a specific time $t_0$ is linked, in order to determine the state of charge for a general time t, to other methods for determination of the state of charge or else to methods for determination of the change in the state of charge $\Delta$SOC ($t_0$, t) in the time from to to t, with $\Delta$SOC ($t_0$, t) preferably being calculated from the amount of charge added or removed, as determined by integration of the current flowing through the rechargeable battery.

8. Method according to one or more of Claims 1 to 7, **characterized in that** the state of charge values SOC ($t_i$) obtained at different times $t_i$ are linked to other methods for determination of state of charge values or to methods for determination of the change in the state of charge $\Delta$SOC ($t_i$, $ti_{+1}$) in the time $t_i$ to $t_{i+1}$, and an instantaneous state of charge value SOC is determined by use of a minimization method.

9. Method according to one or more of Claims 1 to 8, **characterized in that** the voltage values Uo obtained are compared with a limit value Uo-min, and undershooting is indicated and/or an action is taken.

10. Method according to one or more of Claims 1 to 9, **characterized in that** the limit value Uo-min is selected such that it corresponds approximately to the equilibrium voltage of the rechargeable battery after its rated capacity has been withdrawn.

**Revendications**

1. Procédé pour déterminer l'état de charge d'accumulateurs au plomb par estimation de la tension de repos actuelle?

**caractérisé en ce qu'**

on enregistre en même temps des paires de valeurs de mesure ($U_i$, $I_i$) de la tension d'accumulateur et du courant au moment $t_1$ à un, intervalle de temps dt, on ne tient compte que des paires de valeurs pour lesquelles dans le dernier intervalle de temps exclusivement un courant de décharge s'est écoulé, et avec un groupe de paires de valeurs de mesure ($U_i$, $I_i$) ainsi sélectionnées on fait varier les paramètres $U_0$, R et C de telle sorte que la somme des carrés d'écart d'erreur est minimisée entre les valeurs $U_i$ données par la formule

$$U_i = U_0 + R^* I_i + 1/C \int I_i\,dt \quad (1)$$

et les valeurs mesurées $U(t_i)$, et on déduit l'état de charge de l'accumulateur de la tension de repos $U_0$ ainsi obtenue, R étant un facteur de la dimension résistance, C ayant la dimension d'une capacité et $U_0$ représentant la tension de repos déterminée selon cet algorithme.

2.  Procédé selon la revendication 1,
    **caractérisé en ce qu'**
    avec un groupe de paires de valeurs de mesure ($U_i$, $I_i$) ainsi sélectionnées on fait varier les paramètres $U_0$, R, a, $i_0$ et C de telle sorte que la somme des carrés d'écart d'erreur est minimisée entre les valeurs $U_1$ données par la formule

$$U_i = U_0 + R^*I_i + [a^*i_0^*arcsinh(I_i/i_0) - a^*I_i] + 1/C \int I_i\,dt \quad (2)$$

et les valeurs mesurées $U(t_i)$, et l'on déduit l'état de charge de l'accumulateur de la tension ainsi obtenue, R et a étant des facteurs de la dimension résistance, $i_0$ étant un facteur de la dimension intensité de courant, C ayant la dimension d'une capacité et $U_0$ représentant la tension de repos déterminée selon cet algorithme.

3.  Procédé selon la revendication 1 ou 2,
    **caractérisé en ce que**
    des $U_0$ déterminées sont comparées avec des valeurs précédentes dans le temps et seules les valeurs $U_0$ sont prises en compte auxquelles s'applique la relation :

$$dU_0 / dq = (U_0(t_n) - U_0(t_{n-1})) / (q(t_n) - q(t_{n-1})) < Dgr \quad (3)$$

la valeur limite Dgr par cellule étant choisie dans la plage de 6V/Qo à -6V/Qo, de préférence avec la condition Abs (Dgr)<=1 V/Qo, Qo étant alors la capacité de la batterie.

4.  Procédé selon la revendication 1 ou 2,
    **caractérisé en ce que**
    seules les paires de valeurs de mesure ($U_i$, $I_i$) sont utilisées pour lesquelles $I_i$ < O et depuis la dernière valeur de mesure avec un courant positif et un intervalle de temps dt avec contribution positive $Q^+$ à l'état de charge la condition suivante est remplie :

    soit le montant de $Q^-$ est supérieur au montant de $Q^+$, soit le montant de $Q^-$ est supérieur à 2% de la capacité de la batterie,
    $Q^-$ représentant la quantité de charge (déchargée) qui a été soutirée depuis le dernier point de mesure avec courant de batterie positif pendant une phase de décharge ininterrompue,
    et $Q^+$ représentant la quantité de charge (chargée) qui a été rechargée pendant la dernière phase (de charge) ininterrompue avec courant de batterie positif.

5.  Procédé selon l'une ou plusieurs des revendications 1 à 4,
    **caractérisé en ce qu'**
    une synchronisation de la détection de données de mesure et de l'activation et de la désactivation de charges, notamment avec des charges commandées par impulsions, s'effectue de façon à obtenir des paires de valeurs de mesure ($U_i$, $I_i$) avec des intensités de courant $I_1$ différentes.

**6.** Procédé selon l'une ou plusieurs des revendications 1 à 5,
**caractérisé en ce que**
l'activation ou la désactivation de charges est provoquée et ceci de façon à obtenir des paires de valeurs de mesure $(U_i, I_i)$ avec des intensités de courant $I_1$ différentes.

**7.** Procédé selon l'une ou plusieurs des revendications 1 à 6,
**caractérisé en ce que**
la valeur d'état de charge SOC $(t_0)$ ainsi obtenue à un moment to déterminé, pour déterminer l'état de charge au moment général t, est combinée avec d'autres procédés pour déterminer la variation de l'état de charge $\Delta$SOC $(t_0, t)$ pendant le temps de $t_0$ à t, $\Delta$SOC $(t_0, t)$ étant de préférence calculé à partir de la quantité de charge mise en oeuvre déterminée par intégration du courant traversant l'accumulateur.

**8.** Procédé selon l'une ou plusieurs des revendications 1 à 7,
**caractérisé en ce que**
les valeurs d'état de charge SOC $(t_1)$ obtenues à différents moments $t_1$ sont combinées avec d'autres procédés pour déterminer la variation de l'état de charge $\Delta$SOC $(t_i, ti_{+1})$ pendant le temps de $t_i$ à $t_{i+1}$ et une valeur d'état de charge SOC actuelle est déterminée en utilisant un procédé de minimisation.

**9.** Procédé selon l'une ou plusieurs des revendications 1 à 8,
**caractérisé en ce que**
les valeurs de tension $U_0$ obtenues sont comparées avec une valeur limite $U_{0-min}$ et le dépassement négatif est signalé et/ou une mesure est prise.

**10.** Procédé selon l'une ou plusieurs des revendications 1 à 9,
**caractérisé en ce que**
la valeur limite $U_{0-min}$ est choisie de sorte à correspondre sensiblement à la tension d'équilibre de l'accumulateur après le retrait de sa capacité nominale.

**Fig.1**

**Fig.2**

**Fig.3**

**Fig.4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19643012 A1